# FASCICULE DE BREVET EUROPEEN

(11) **EP 3 712 083 B1**
(45) Date de publication et mention de la délivrance du brevet: **06.09.2023**
(21) Numéro de dépôt: 20164941.5
(22) Date de dépôt: 23.03.2020
(51) Int. Cl.: B65D 5/50, G01R 31/28

(54) **SYSTÈME ÉLECTRIQUE AVEC UN EMBALLAGE PORTATIF ADAPTÉ AU CONDITIONNEMENT ET AU TRANSPORT D' AU MOINS UN MICROMODULE DE COMMANDE DE CHARGES ÉLECTRIQUES ET UN BANC D' APPAIRAGE**
ELEKTRISCHES SYSTEM MIT EINER TRAGBAREN HÜLLE, DIE AN DIE VERPACKUNG UND DEN TRANSPORT VON MINDESTENS EINEM MIKROMODUL ZUR STEUERUNG ELEKTRISCHER LADUNGEN ANGEPASST IST, UND PAIRING-BANK
ELECTRICAL SYSTEM WITH PORTABLE PACKAGING SUITABLE FOR PACKAGING AND TRANSPORT OF AT LEAST ONE MICROMODULE FOR CONTROLLING ELECTRICAL LOADS AND A BENCH FOR PAIRING

(30) Priorité: 21.03.2019 FR 1902962
(43) Date de publication de la demande: 23.09.2020
(73) Titulaire: Somfy Activites SA, 74300 Cluses (FR)
(72) Inventeur: BOUFFET, Nicolas, 74300 Cluses (FR); RYCKEMBUSCH, Thomas, 74300 Cluses (FR); RICOU, Sébastien, 74960 Annecy (FR); COSSERAT, Hubert, 74300 Cluses (FR); RETY, Claudia, 74300 Cluses (FR)
(74) Mandataire: Germain Maureau

(56) Documents cités:
- EP-A1- 2 963 771
- WO-A1-2012/172242
- JP-A- 2005 082 194
- US-A- 5 499 711

## Description

### Domaine technique de l'invention

La présente invention concerne notamment un système électrique au moins un module de commande destiné à être utilisé dans une installation domotique, où ledit au moins un module de commande est configuré pour assurer une commande d'une charge électrique.

L'invention trouve une application notamment dans le conditionnement, le transport, les opérations d'appairage et d'installation in situ de modules de commande où chaque module de commande est destiné à commander une charge électrique telle qu'une lampe, ou divers équipements électriques tels que des pompes de piscine, chauffe-eau, moteurs, ventilateurs, congélateurs, radiateurs, télévisions, électroménagers, appareils d'arrosage de jardin, volets roulants ou stores...

### Etat de la technique

De tels modules de commande, également considérés comme des micromodules en raison de leur encombrement faible, sont connus. Ils sont destinés à être insérés en série sur un circuit électrique destiné à une commande câblée de la charge électrique. Ces modules de commande peuvent notamment comprendre un récepteur radiofréquence adapté à une communication avec un contrôleur distant après un appairage préalable, un commutateur électronique tel qu'un relais à contact sec destiné à agir sur le circuit électrique de la charge électrique, ainsi qu'une unité électronique telle qu'un microprocesseur, dont une entrée est reliée au récepteur radiofréquence et dont une sortie agit sur le commutateur électronique. Il devient possible d'agir sur le circuit électrique de la charge électrique via le module de commande par une action à distance via le contrôleur distant qui est autorisé à communiquer, par exemple de manière bidirectionnelle, avec le module de commande. D'autres modules de commande, dits module de commande émetteur, peuvent alternativement comprendre un émetteur radiofréquence adapté à une communication avec un récepteur distant, par exemple un module de commande récepteur, après un appairage préalable, ainsi qu'une unité électronique telle qu'un microprocesseur, dont une entrée est reliée à un interrupteur et dont une sortie est reliée à l'émetteur radiofréquence. Ces modules de commande émetteurs, permettent ainsi de transmettre par radio un ordre de commande provoqué par une activation de l'interrupteur auquel il est relié, vers un module de commande associé au circuit électrique de la charge électrique à piloter.

Les modules de commande sont généralement installés en rénovation dans des espaces très restreints, qui n'étaient à l'origine prévus que pour le passage de câbles. A titre d'exemple, un module de commande doit pouvoir venir s'implanter dans une boite murale en lieu et place, ou à l'arrière, d'un interrupteur de commande de la charge électrique que le module de commande est destiné à remplacer. Les modules de commande se doivent donc d'être de faible encombrement, typiquement pour être invisibles. Dès lors, il est contraignant d'agencer les moyens d'interface homme-machine solidaires du module de commande qui permettent notamment à un installateur de programmer le module de commande.

Un équipement de télé-conduite est connu du document EP 2 963 771 A1 et une structure d'emballage du document JP 2005 082194 A.

En outre, bien que ces modules de commande soient prévus de base pour permettre une commande à distance de la charge électrique, il peut parfois être souhaitable qu'ils puissent gérer une pluralité de fonctions autres que la simple commande d'allumage ou d'extinction de la charge. L'une des difficultés est de parvenir alors à ce qu'il soit possible d'apporter un choix de multiples fonctions de commande de la charge électrique de manière conviviale et fiable en dépit des contraintes de conception de l'interface homme-machine du module de commande.

Ces problématiques étant posées, elles sont susceptibles de se présenter que l'installateur réalise l'appairage et le réglage des modules de commande directement sur site ou non, c'est-à-dire même s'il réalise l'appairage et les réglages préalablement à la mise en place de l'installation domotique sur site. L'appairage des modules de commande se pratique par une gestion unitaire des modules de commande, les modules de commande étant traités successivement les uns après les autres, ce qui représente un temps important.

Par ailleurs, quelle que soit la manière de gérer les opérations d'appairage et de réglage des différents modules de commande d'une installation domotique, la gestion logistique des modules de commande représente une difficulté supplémentaire. Une installation domotique donnée peut en effet comprendre un ensemble prédéterminé de modules de commande ayant un nombre conséquent de modules de commande, par exemple un nombre supérieur ou égal à 6.

L'une des problématiques à surmonter est d'abord de gérer de manière fiable et sécuritaire les opérations d'appairage et de réglage des modules de commande en s'assurant du suivi et de l'identification de chacun des modules pour éviter tout risque de perte ou d'inversion des modules de commande durant ces opérations et durant le transport et la mise en place de l'installation domotique sur site.

Une autre problématique repose sur le fait que la personne chargée des opérations d'appairage et de réglage et/ou l'installateur sur site est dans l'obligation de manipuler unitairement tous les modules de commande, ce qui, au-delà de l'aspect peu convivial, renforce les risques de perte ou d'inversion éventuelle des modules de commande. Cela représente également une perte de temps, notamment pour le déballage des emballages de protection des modules de commande, puis le stockage dans un autre contenant après appairage et réglage voire le remballage en vue du transport vers le site final.

La gestion logistique des modules de commande est également une difficulté en raison de la production d'une quantité importante de déchets, notamment les emballages de protection des modules de commande qui se présentent sous la forme de boites unitaires, les notices d'instructions de montage et d'utilisation présentes dans chacune des boites, les moyens de calage des modules de commande à l'intérieur des boites etc... En dehors de l'encombrement général et du temps perdu à cette gestion, la production d'une telle quantité de déchets revêt une dimension écologique qui n'est pas satisfaisante.

### Objet de l'invention

La présente invention a pour but de proposer une solution économique et conviviale, sécuritaire en limitant les risques de perte et d'inversion de modules de commande, qui facilite les opérations d'appairage et de réglage éventuel des modules de commande ainsi que la gestion logistique des modules de commande pendant leur cycle de vie depuis le stockage après leur production jusqu'à leur installation finale en passant par différentes étapes de manipulation, tout en étant plus écologique et en optimisant l'efficience générale en limitant les pertes de temps et les manipulations inutiles des modules de commande et des déchets.

Ce but peut être atteint grâce à la fourniture d'un système électrique comprenant :
- un ensemble prédéterminé de modules de commande destinés à être utilisés dans une même installation domotique, où chaque module de commande est configuré pour assurer une commande d'une charge électrique,
- un emballage, portatif adapté au conditionnement et au transport de l'ensemble prédéterminé de modules de commande, ledit emballage étant tel que le nombre de modules de commande dudit ensemble prédéterminé puisse être supérieur ou égal à 2, préférentiellement supérieur ou égal à 6, ledit emballage délimitant au moins une paroi de support dans laquelle sont ménagées une pluralité de découpes de positionnement où le nombre de découpes de positionnement de ladite pluralité est supérieur ou égal au nombre de modules de commande dudit ensemble prédéterminé, chaque découpe de positionnement étant configurée de sorte à permettre un emboîtement à force de l'un des modules de commande par une insertion au moins partielle de ce module de commande dans la découpe de positionnement, ledit emboîtement conférant un blocage relatif du module de commande (10) par rapport à l'emballage et un maintien du module de commande dans une position bloquée,
- un banc d'appairage adapté à réaliser un appairage de l'un des modules de commande de l'ensemble prédéterminé avec un autre module de commande de l'ensemble prédéterminé et/ou avec un émetteur radiofréquence distant destiné à être utilisé dans la même installation domotique que les modules de commande de l'ensemble prédéterminé, dans lequel l'emballage comprend des premiers éléments de fixation configurés pour coopérer avec des seconds éléments de fixation solidaires d'un carter du banc d'appairage d'une manière telle que lorsque les premiers éléments de fixation et les seconds éléments de fixation coopèrent entre eux, l'emballage est fixé temporairement au carter du banc d'appairage.

Certains aspects préférés mais non limitatifs de ce système électrique sont les suivants.

Le banc d'appairage comprend tout ou partie des éléments suivants :
- des éléments de raccordement à une source électrique,
- un bloc d'alimentation électrique permettant d'alimenter électriquement l'émetteur radiofréquence distant depuis le banc d'appairage,
- des connecteurs électriques adaptés à une connexion et une déconnexion rapides à au moins un câble électrique dépassant hors d'un boitier du module de commande et destiné à être connecté à une source électrique d'alimentation du module de commande et/ou à un circuit électrique auquel la charge électrique à commander par le module de commande appartient, lesdits connecteurs électriques permettant une alimentation électrique des modules de commande par le banc d'appairage,
- au moins un port d'entrée-sortie pour raccorder le banc d'appairage à l'émetteur radiofréquence distant ou à une interface homme-machine, tel qu'un écran et/ou un clavier,
- des éléments de confirmation visuels et/ou auditifs pour confirmer la présence ou l'absence d'appairage de chacun des modules de commande de l'ensemble prédéterminé avec un autre module de commande et/ou avec l'émetteur radiofréquence distant.

Au moins l'un des modules de commande de l'ensemble prédéterminé est susceptible d'occuper un mode de fonctionnement ou un mode de configuration comprenant un état initial et une pluralité d'états de configuration et le banc d'appairage comprend d'une part un interrupteur basculant procurant deux positions stables et/ou un interrupteur de type bouton poussoir procurant une unique position stable permettant une sélection de l'état de configuration et d'autre part au moins un témoin lumineux pour vérifier la modification de l'état de configuration et/ou l'état de configuration sélectionné.

L'emballage délimite au moins un oeillet de maintien à contour fermé associé à chaque découpe de positionnement et disposé à proximité de la découpe de positionnement à laquelle il est associé, le nombre d'oeillets de maintien étant égal au nombre de découpes de positionnement, chaque oeillet de maintien étant adapté à permettre le passage à travers ledit oeillet de maintien d'au moins un câble électrique dépassant d'un boitier du module de commande qui est engagé à force dans la découpe de positionnement à laquelle ledit oeillet de maintien est associé.

Ce but peut aussi être atteint grâce à la fourniture d'un système électrique comprenant :
- un module de commande destiné à être utilisé dans une installation domotique et configuré pour assurer une commande d'une charge électrique,
- un emballage, portatif adapté au conditionnement et au transport du module de commande, ledit emballage délimitant au moins une paroi de support dans laquelle une découpe de positionnement unique est ménagée, la découpe de positionnement étant configurée de sorte à permettre un emboîtement à force du module de commande par une insertion au moins partielle du module de commande dans la découpe de positionnement, ledit emboîtement conférant un blocage relatif du module de commande par rapport à l'emballage et un maintien du module de commande dans une position bloquée,
- un banc d'appairage adapté à réaliser un appairage du module de commande avec un autre module de commande utilisé dans ladite installation domotique et/ou avec un émetteur radiofréquence distant destiné à être utilisé dans ladite installation domotique, dans lequel l'emballage comprend des premiers éléments de fixation configurés pour coopérer avec des seconds éléments de fixation solidaires d'un carter du banc d'appairage d'une manière telle que lorsque les premiers éléments de fixation et les seconds éléments de fixation coopèrent entre eux, l'emballage est fixé temporairement au carter du banc d'appairage.

Certains aspects préférés mais non limitatifs de ce système électrique sont les suivants.

Le banc d'appairage comprend tout ou partie des éléments suivants :
- des éléments de raccordement à une source électrique,
- un bloc d'alimentation électrique permettant d'alimenter électriquement l'émetteur radiofréquence distant depuis le banc d'appairage,
- des connecteurs électriques adaptés à une connexion et une déconnexion rapides à au moins un câble électrique dépassant hors d'un boitier du module de commande et destiné à être connecté à une source électrique d'alimentation du module de commande et/ou à un circuit électrique auquel la charge électrique à commander par le module de commande appartient, lesdits connecteurs électriques permettant une alimentation électrique de chaque module de commande par le banc d'appairage,
- au moins un port d'entrée-sortie pour raccorder le banc d'appairage à l'émetteur radiofréquence distant ou à une interface homme-machine, tel qu'un écran et/ou un clavier,
- des éléments de confirmation visuels et/ou auditifs pour confirmer la présence ou l'absence d'appairage du module de commande avec un autre module de commande et/ou avec l'émetteur radiofréquence distant.

Le module de commande est susceptible d'occuper un mode de fonctionnement ou un mode de configuration comprenant un état initial et une pluralité d'états de configuration et le banc d'appairage comprend d'une part un interrupteur basculant procurant deux positions stables et/ou un interrupteur de type bouton poussoir procurant une unique position stable permettant une sélection de l'état de configuration et d'autre part au moins un témoin lumineux pour vérifier la modification de l'état de configuration et/ou l'état de configuration sélectionné.

L'emballage délimite un oeillet de maintien à contour fermé disposé à proximité de la découpe de positionnement unique, l'oeillet de maintien étant adapté à permettre le passage à travers ledit oeillet de maintien d'au moins un câble électrique dépassant d'un boitier du module de commande qui est engagé à force dans la découpe de positionnement.

Quel que soit le système électrique précédemment décrit, les caractéristiques suivantes peuvent être appliquées isolément ou en combinaison.

Chaque module de commande comprend :
- un module d'émission et/ou de réception radiofréquence pour émettre des signaux radiofréquence vers un récepteur radiofréquence distant et/ou recevoir des signaux radiofréquence en provenance d'un émetteur radiofréquence distant destiné à être utilisé dans la même installation domotique,
- au moins un commutateur électrique adapté à ouvrir ou fermer le circuit électrique auquel la charge électrique à commander par le module de commande appartient,
- une unité électronique dont une entrée est reliée au module d'émission et de réception radiofréquence et dont une sortie agit sur le commutateur électrique.

L'emballage est constitué en une seule pièce formée dans un matériau léger et recyclable, notamment une matière cartonnée, susceptible d'être conformée au moins par pliage à partir d'un patron initial, la paroi de support venant de matière depuis le reste de la pièce constitutive de l'emballage.

L'emballage délimite au moins une première partie et une deuxième partie mobile par rapport à la première partie, où la première partie délimite la paroi de support et où la deuxième partie comprend au moins un rabat susceptible de venir occuper une configuration de fermeture dans laquelle le rabat est rapporté et fixé de manière réversible contre la première partie, la deuxième partie étant telle que lorsque le rabat occupe la configuration de fermeture, la deuxième partie recouvre la paroi de support avec interposition d'un intervalle dans lequel chaque module de commande maintenu en position bloquée au niveau d'une découpe de positionnement est partiellement logé.

Le rabat de la deuxième partie est susceptible d'occuper une configuration d'ouverture distincte de la configuration de fermeture et dans laquelle la deuxième partie est spatialement conformée de telle sorte que la paroi de support est accessible depuis l'extérieur de l'emballage d'une manière permettant la mise en place et le retrait de chaque module de commande vers ou hors de sa position bloquée.

L'emballage comprend au moins une zone de repérage accessible depuis l'extérieur de l'emballage permettant de renseigner au moins une information relative à l'installation domotique au sein de laquelle chaque module de commande est destiné à être utilisé.

Pour chaque module de commande maintenu en position bloquée dans une découpe de positionnement, le module de commande comprend au moins une zone d'identification accessible depuis l'extérieur de l'emballage, la zone d'identification permettant de renseigner au moins une information relative au module de commande, notamment au moins une information choisie parmi un nom de repérage, une fonction remplie par le module de commande, un nom de la charge électrique destinée à être commandée par le module de commande, un nom d'une pièce où le module de commande est destiné à être implanté.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
La figure 1 est une vue en perspective d'un exemple d'emballage d'un système électrique selon l'invention en configuration d'ouverture.
La figure 2 est une vue en perspective de l'emballage en configuration de fermeture.
La figure 3 est une vue en perspective d'un exemple de système électrique selon l'invention avec trois modules de commande.
La figure 4 est une vue en perspective d'un détail du système électrique au niveau de l'un des modules de commande.
La figure 5 est une vue en perspective avant d'un exemple de système électrique ayant sept modules de commande.
La figure 6 est une vue schématique en perspective illustrant partiellement un exemple de système électrique selon l'invention.
La figure 7 est une représentation schématique d'une installation domotique comprenant un module de commande d'une charge électrique d'éclairage.
La figure 8 est une représentation schématique du module de commande de la charge électrique d'éclairage.
La figure 9 est une représentation schématique d'une variante du module de commande de la charge électrique d'éclairage.

### Description détaillée

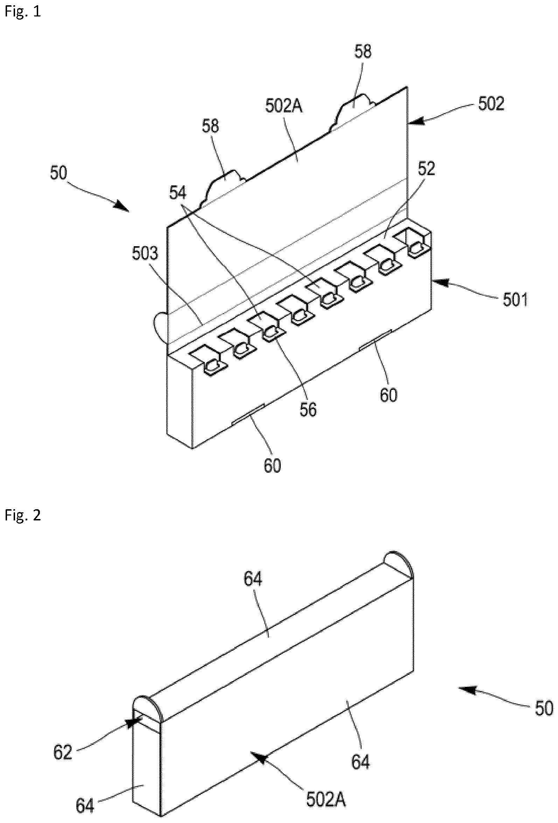

En référence aux figures 1 à 9 présentées sommairement ci-avant, il est ici décrit un emballage 50 portatif adapté au conditionnement et au transport d'au moins un module de commande 10, typiquement un ensemble prédéterminé de modules de commande 10, chacun étant destiné à être utilisé dans une même installation domotique, chaque module de commande 10 étant configuré pour assurer une commande d'une charge électrique 1.

Selon un mode de réalisation particulier, l'emballage 50 est avantageusement tel que le nombre de modules de commande 10 de l'ensemble prédéterminé puisse être supérieur ou égal à 2, préférentiellement supérieur ou égal à 6. Toutefois, il reste possible de prévoir que le nombre de module de commande 10 soit égal à 1 et que l'emballage ne soit adapté au conditionnement et au transport que de cet unique module de commande 10.

Chaque module de commande 10 est destiné à commander une charge électrique 1 telle qu'une lampe, ou divers équipements électriques tels que des pompes de piscine, chauffe-eau, moteurs, ventilateurs, congélateurs, radiateurs, télévisions, électroménagers, appareils d'arrosage de jardin, un moteur de volet roulant ou de store...

Chaque module de commande 10, ou micromodule en raison de son encombrement faible, est destiné à être inséré en série sur un circuit électrique 2 destiné à une commande câblée de la charge électrique 1.

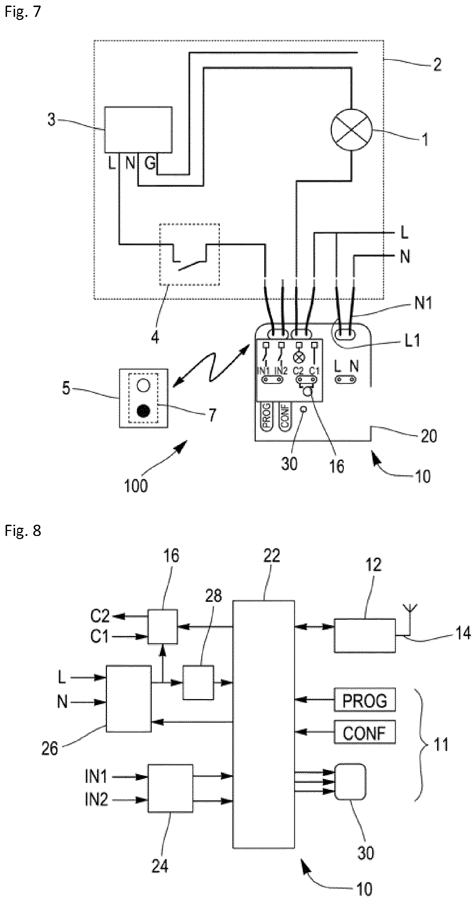

Si la nature des modules de commande 10 n'est pas véritablement limitative en soi, chaque module de commande 10 peut notamment comprendre, en référence aux figures 7 à 9, un boitier 20 et au moins un câble électrique L1, N1 dépassant hors du boitier 20 et destiné à être connecté à une source électrique d'alimentation du module de commande 10 et/ou au circuit électrique 2 auquel la charge électrique 1 à commander par le module de commande 10 appartient.

Chaque module de commande 10 comprend préférentiellement :
- un module d'émission et/ou de réception radiofréquence 12 pour émettre des signaux radiofréquence vers un récepteur radiofréquence distant et/ou recevoir des signaux radiofréquence en provenance d'un émetteur radiofréquence distant 5 destiné à être utilisé dans une même installation domotique,
- au moins un commutateur électrique 16 adapté à ouvrir ou fermer le circuit électrique 2 auquel la charge électrique 1 à commander par le module de commande 10 appartient,
- une unité électronique 22 dont une entrée est reliée au module d'émission et de réception radiofréquence 12 et dont une sortie agit sur le commutateur électrique 16.

Selon un mode de réalisation particulier, au moins l'un des modules de commande 10 comprend une interface homme-machine 11 ayant un témoin lumineux par exemple sous la forme d'une diode électroluminescente 30 et une touche de configuration repérée « CONF » permettant au module de commande 10 de basculer d'un mode de fonctionnement à un mode de configuration comprenant un état initial signalé par un état lumineux du témoin lumineux et une pluralité d'états de configuration et de modifier d'état de configuration par des actions sur la touche de configuration CONF.

Par « interface homme-machine », on entend une interface au travers de laquelle une personne, un installateur ou un utilisateur, peut interagir avec le module de commande 10.

A titre d'exemple, dans le mode de configuration, l'état initial est signalé par un état allumé ininterrompu du témoin lumineux tandis que le mode de fonctionnement est distingué par un état éteint du témoin lumineux. Ainsi, la distinction entre le mode de fonctionnement et le mode de configuration est clairement définie et applicable quelle que soit la nature de la charge électrique. D'autre part, à la fin de chaque étape de configuration, le retour à l'état initial du mode de configuration est également clairement identifié.

L'unité électronique 22 peut être paramétrée de sorte qu'une action sur la touche de configuration CONF sous forme d'un premier appui particulier dans le mode de fonctionnement permet le basculement du module de commande 10 du mode de fonctionnement au mode de configuration et qu'une action sous forme d'un deuxième appui particulier dans le mode de configuration permet la sortie du mode de configuration et le retour au mode de fonctionnement. Alternativement ou en combinaison, il peut être prévu un retour dans le mode de fonctionnement après une durée prédéterminée sans action sur la touche de configuration CONF ou suite à une coupure d'alimentation du module de commande 10.

Selon un mode de réalisation, il est prévu une analyse de la durée d'un appui sur la touche de configuration CONF avant un relâché de la touche, un appui simple ayant une durée prédéfinie et un appui particulier ayant une durée supérieure à la durée d'un appui simple.

L'unité électronique 22 peut être paramétrée pour réaliser un comptage du nombre d'actions sur la touche de configuration CONF, la sélection d'un état de configuration se pratiquant en fonction du nombre d'actions sur la touche de configuration CONF. Chaque état de configuration peut être repérable par une séquence particulière d'états du témoin lumineux. Chaque séquence particulière peut débuter par un passage de la diode électroluminescente 30 par un état éteint suivi par un clignement de la diode électroluminescente 30 dépendant de l'état de configuration sélectionné.

Il est prévu un retour dans l'état initial du mode de configuration après une durée prédéterminée suivant la sélection d'un état de configuration.

Ainsi, chaque module de commande 10 est apte à :
- distinguer des appuis simples d'appuis particuliers, dont la durée d'appui est différente de celle des appuis simples, sur la touche de configuration CONF, un premier appui particulier sur la touche de configuration permettant le basculement du module de commande 10 du mode de fonctionnement au mode de configuration, un deuxième appui particulier permettant la sortie du mode de configuration et le retour au mode de fonctionnement,
- sélectionner un état de configuration parmi une pluralité d'états de configuration disponibles,
- comptabiliser un nombre d'appuis simples dans le mode de configuration pour sélectionner un état de configuration parmi au moins trois états de configuration,
- sélectionner l'état de configuration choisi en fonction du nombre d'appuis simples,
- retourner dans l'état initial du mode de configuration en l'absence d'appui simple pendant une durée déterminée,
- quitter une séquence de configuration en cas d'erreur, sans nécessairement quitter le mode de configuration. En cas d'erreur de comptage, l'utilisateur a la possibilité de quitter le mode de configuration et/ou de retourner à l'état initial du mode de configuration sans enregistrement de l'état sélectionné.

Le module de commande 10 peut également comprendre tout composant électronique matériel et/ou tout composant logiciel pour son fonctionnement, comme par exemple une mémoire (non représentée) ou des programmes d'ordinateur stockés dans une mémoire, par exemple une mémoire de l'unité électronique 22.

Il est décrit un exemple non limitatif en référence aux figures 7 à 9, pour donner au lecteur une bonne compréhension des modules de commande 10.

La figure 7 montre une installation domotique 100 installée dans un bâtiment. L'installation domotique comprend d'une part, une charge électrique 1, dans l'exemple ci-dessous une charge électrique d'éclairage telle qu'une lampe d'un luminaire. La charge électrique 1 peut toutefois être un autre type d'équipement électrique tel qu'une pompe, un chauffe-eau, un moteur, un ventilateur, un radiateur, un appareil de télévision, un appareil électroménager ou un appareil d'arrosage de jardin, un moteur de volet roulant ou de store. La charge électrique 1 est intégrée dans un circuit électrique 2 alimenté par le secteur et comprenant des conducteurs d'alimentation Phase L et Neutre N. Un tableau électrique 3 fournit l'alimentation secteur aux conducteurs d'alimentation L et N. Le tableau électrique 3 représenté comprend également un conducteur G relié à la terre.

L'installation domotique 100, en particulier le circuit électrique 2 comprend en outre un interrupteur mural 4, adapté pour agir sur l'ouverture ou la fermeture du circuit électrique 2 et ainsi, adapté pour commander l'état allumé ou éteint de la charge électrique 1.

L'installation domotique 100 comprend au moins un émetteur radiofréquence distant 5, tel qu'une télécommande, typiquement muni d'une interface de commande 7.

L'installation domotique 100 comprend également un module de commande 10, lequel est inséré en série sur le circuit électrique 2. Le système électrique comprend un ensemble prédéterminé de tels modules de commande 10, dont le nombre est supérieur ou égal à 1, et par exemple supérieur ou égal à 6. Chaque module de commande 10 est destiné à être utilisé au sein d'une même installation domotique 100 incluant en outre l'émetteur radiofréquence distant 5.

Ainsi qu'illustré sur la figure 8, le module de commande 10 comprend un module d'émission et de réception radiofréquence 12. Le module d'émission et de réception radiofréquence 12 comprend notamment des moyens électroniques pour recevoir et/ou émettre des signaux radiofréquence en provenance de l'émetteur radiofréquence distant 5, dont une antenne 14.

Le module de commande 10 et l'émetteur radiofréquence distant 5 ont au préalable échangé des paramètres d'authentification, selon des procédés connus d'appairage, de sorte à ce qu'ils sont autorisés à communiquer l'un avec l'autre, notamment de manière bidirectionnelle, comme indiqué par la double flèche. Ces paramètres d'authentification sont par exemple un ou plusieurs identifiants et/ou une clé de cryptage. Le module de commande 10 et l'émetteur radiofréquence distant 5 sont en situation d'appairage lorsqu'ils ont échangé ces paramètres d'authentification, de sorte qu'un ordre de commande, émis au travers de l'interface de commande 7 de l'émetteur radiofréquence distant 5 puisse être reçu, puis exécuté par le module de commande 10, conformément à un protocole de communication.

Pour parvenir à un tel appairage, il est nécessaire de réaliser des opérations au niveau de chaque module de commande 10 voire au niveau de l'émetteur radiofréquence distant 5 et c'est un objet du banc d'appairage 200 décrit plus loin que de permettre de mettre en oeuvre ces opérations simultanément pour tous les modules de commande 10 de l'ensemble prédéterminé. Le banc d'appairage 200 peut également servir à régler tous les modules de commande 10, notamment pour éventuellement sélectionner pour chacun d'eux l'un des états de configuration parmi ceux disponibles.

Le module de commande 10 comprend une unité électronique 22, telle qu'un microprocesseur. Le module de commande 10 comprend également un commutateur électronique 16, tel qu'un relais, un triac, un transistor, ou tout autre élément permettant de commuter un circuit électrique. Ce commutateur électronique 16 est placé en série avec des conducteurs électriques C1, C2 de sorte à ouvrir ou fermer le circuit électrique 2.

Le module de commande 10 comprend également au moins les conducteurs d'alimentation L1, N1, dépassant d'un boîtier 20 du module de commande 10 et adaptés à être connectés aux lignes d'alimentation secteur L et N, les conducteurs électriques référencés C1, C2, adaptés à être connectés l'un à une ligne d'alimentation secteur L et N et l'autre à la charge électrique 1 et au moins un conducteur d'entrée IN1, adapté à être connecté en série ici avec l'interrupteur mural 4. Les conducteurs L1 et N1 servent à l'alimentation du module de commande 10. Ils sont reliés à un premier bloc 26 convertisseur de tension, lequel permet notamment de redresser et d'abaisser la tension secteur disponible à un premier niveau de tension, en particulier une très basse tension, de l'ordre de 5 à 12V continue, permettant d'alimenter le commutateur électronique 16. Un deuxième bloc 28 abaisseur de tension, permet d'abaisser la très basse tension disponible en sortie d'un premier bloc 26 convertisseur de tension, à un deuxième niveau de tension, en particulier une très basse tension, de l'ordre de 3V continue, permettant d'alimenter l'unité électronique 22.

Une entrée de l'unité électronique 22 est reliée au module d'émission et de réception radiofréquence 12, une entrée de l'unité électronique 22 est reliée au conducteur d'entrée IN1 au travers d'un bloc 24 d'analyse de tension. Cette entrée fournit ainsi une information sur l'état (activé ou non) de l'interrupteur mural 4. Ce bloc 24 d'analyse de tension peut également fournir un signal sur une autre entrée de l'unité électronique 22, relative à l'activation ou non d'un deuxième interrupteur mural, non représenté, par le biais d'un deuxième conducteur d'entrée IN2.

Une sortie de l'unité électronique 22 agit sur le commutateur électronique 16. Le fonctionnement du module de commande 10 est le suivant : lorsqu'un utilisateur agit sur l'interrupteur mural 4 ou sur l'interface de commande 7 de l'émetteur radiofréquence distant 5 pour alimenter la charge électrique 1, l'information est reçue par l'unité électronique 22 qui analyse l'information en entrée et agit sur le commutateur électronique 16 pour fermer le circuit électrique 2. La charge électrique 1 est alimentée en conséquence. Inversement, lorsqu'un utilisateur agit sur l'interrupteur mural 4 ou sur l'interface de commande 7 de l'émetteur radiofréquence distant 5 pour ne plus alimenter la charge électrique 1, l'information est reçue par l'unité électronique 22 qui analyse l'information en entrée et agit sur le commutateur électronique 16 pour ouvrir le circuit électrique 2. La charge électrique 1 n'est plus alimentée.

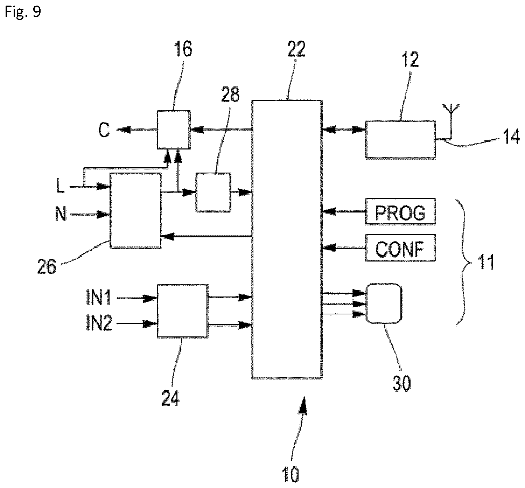

Selon une variante représentée à la figure 9, le commutateur électronique 16 est connecté à l'une des lignes d'alimentation secteur L, N, par exemple à la ligne de phase L. Le commutateur électronique 16 pilote la connexion de la phase L à un conducteur de sortie C relié à la charge électrique 1, en fonction de l'état de la sortie de l'unité électronique 22. Le conducteur de sortie C correspond à ce qui est appelé une phase commutée.

Le module de commande 10 tel que décrit ci-dessus permet de mettre en oeuvre des commandes basiques d'allumage ou d'extinction de la charge électrique 1. Grâce à la touche de configuration CONF, il est possible d'ajouter des fonctions de commande de la charge électrique 1, dans la mesure où l'intégration d'un émetteur radiofréquence distant 5 avec une interface de commande 7 qui peut être évoluée (comprenant notamment un écran ou un afficheur) permet de sélectionner une commande parmi une pluralité de fonctions de commande, correspondant chacune à un état de configuration sélectionnable dans le module de commande 10.

La touche de configuration CONF est par exemple sous la forme d'un bouton poussoir. Un bouton poussoir est notamment un bouton qui doit être maintenu appuyé sans quoi il retourne dans une position de repos. Il peut être qualifié d'interrupteur à position momentanée.

La configuration de multiples états de configuration intervient à partir de la touche de configuration CONF. Autrement dit, les états de configuration du module de commande 10 sont accessibles à partir de la touche de configuration CONF.

A titre d'exemple, le module de commande 10 est adapté à sélectionner des états de configuration parmi les catégories suivantes :
- Remise à zéro des paramètres de configuration,
- Choix du type d'interrupteur filaire associé au module de commande,
- Sélection du statut après une coupure de courant,
- Gestion de temporisation.

A chacune des catégories peut correspondre plusieurs états de configuration.

L'émetteur radiofréquence distant 5 est par exemple une télécommande simple, à boutons de commande, une télécommande intelligente, munie d'écran de commande, une tablette ou téléphone intelligent ou une box domotique contrôlée elle-même par des tablettes ou téléphones intelligents.

Le module de commande 10 peut également être appairé avec un module de commande émetteur, lequel peut être installé en lieu et place d'un interrupteur mural 4 ou en parallèle avec un tel interrupteur mural 4.

Le module de commande 10 peut également être appairé avec un capteur ou une box domotique. Celle-ci peut notamment servir de passerelle de commande entre au moins un émetteur radiofréquence distant 5 ou capteur distant et le module de commande 10, en retransmettant les ordres de commande qu'elle reçoit au module de commande 10.

Selon un autre mode de réalisation particulier, l'interface homme-machine 11 d'au moins l'un des modules de commande 10 de l'ensemble prédéterminé comprend en outre une touche de programmation repérée « PROG » configurée de sorte que des actions sur la touche de programmation PROG permet un appairage du module de commande 10 avec un autre module de commande 10 de l'ensemble prédéterminé et/ou avec un émetteur radiofréquence distant 5 ou un récepteur radiofréquence destinés à être utilisé dans une même installation domotique 100. Cette touche de programmation PROG peut être un bouton poussoir de manière similaire à la touche de configuration CONF. Cette touche de programmation PROG est utilisée entre autres pour appairer le module de commande 10 avec au moins un émetteur radiofréquence distant 5 et/ou avec au moins un autre module de commande 10 de l'ensemble prédéterminé, cet appairage se faisant conformément à des procédés connus.

La touche de programmation PROG peut être utilisée de manière similaire à la touche de configuration CONF. Elle permet en effet l'entrée dans un mode de programmation, distinct du mode de fonctionnement et distinct du mode de configuration. Toutefois, pour distinguer le mode de programmation du mode de configuration, il est nécessaire de ne pas le signaler de manière équivalente au mode de configuration. La diode électroluminescente 30 peut ainsi être utilisée en éclairage continu, mais avec une couleur distincte du mode de configuration, ou éclairer par intermittence.

L'emballage 50 visible par exemple sur les figures 1 et 2 délimite au moins une paroi de support 52 dans laquelle sont ménagées une pluralité de découpes de positionnement 54 où le nombre de découpes de positionnement 54 de cette pluralité est supérieur ou égal au nombre de modules de commande 10 de l'ensemble prédéterminé de modules de commande 10. Chaque découpe de positionnement 54 est configurée de sorte à permettre un emboîtement à force de l'un des modules de commande 10 par une insertion au moins partielle de ce module de commande 10 dans la découpe de positionnement 54. Cet emboîtement confère un blocage relatif du module de commande 10 par rapport à l'emballage 50 et un maintien du module de commande 10 dans une position dite bloquée.

Chacun des modules de commande 10 de l'ensemble prédéterminé est emboîté à force dans l'une des découpes de positionnement 54 délimitées par la paroi de support 52 elle-même délimitée par l'emballage 50 par une insertion au moins partielle dans la découpe de positionnement 54 correspondante de sorte à être maintenu dans sa position bloquée par rapport à l'emballage 50. Le module de commande 10 peut ainsi être maintenu temporairement dans l'emballage 50, retiré de la découpe de positionnement 54 si besoin et repositionné dans une autre découpe de positionnement 54 du même emballage 50 ou d'un autre emballage 50.

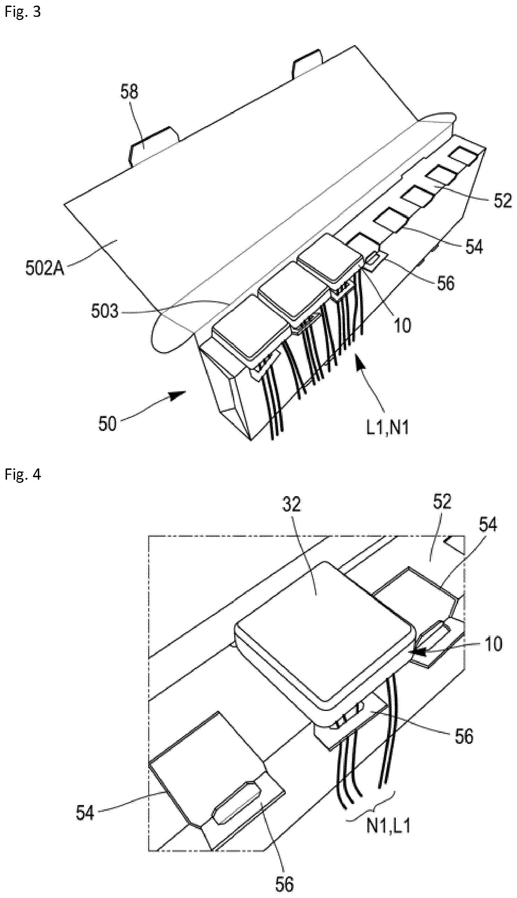

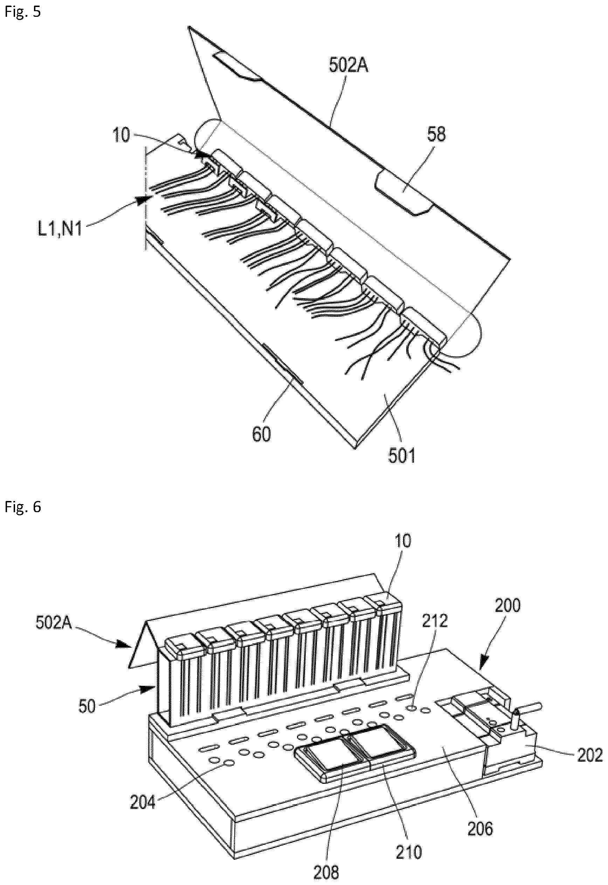

Les figures 1 et 2 montrent l'emballage 50 seul, c'est-à-dire dépourvu de module de commande 10 maintenu en position bloquée. Au contraire, la figure 3 montre que trois des huit découpes de positionnement 54 délimitées au total par la paroi de support 52 sont occupées, par engagement à force, par trois modules de commande 10 de l'ensemble prédéterminé. Autrement dit, chacun de ces trois modules de commande 10 occupe sa position bloquée relativement à l'emballage 50. Il en résulte que ces modules de commande 10 en position bloquée sont stockés de manière certaine et que le seul transport de l'emballage 50 permet de transporter ensemble les différents modules de commande 10. Ce transport et ce stockage des modules de commande 10 par l'intermédiaire d'un seul et même emballage 50 peut très avantageusement intervenir pendant leur cycle de vie depuis le stockage après leur production jusqu'à leur installation finale en passant par les différentes étapes de manipulation, notamment les manipulations nécessaires à l'appairage et au réglage des modules de commande via le banc d'appairage 200 au niveau duquel il n'est même pas nécessaire de sortir les modules de commande 10 hors de leurs positions bloquées, évitant des manipulations inutiles et des risques de perte ou d'inversion. Sur la figure 4, un seul module de commande 10 est représenté en position bloquée, au contraire des figures 5 et 6 où chacune des huit découpes de positionnement 54 reçoit par engagement à force un module de commande 10 correspondant.

Pour chaque module de commande 10 ainsi maintenu en position bloquée dans l'une des découpes de positionnement 54, au moins l'un des câbles électriques, typiquement au moins l'un des câbles électriques L1, N1, qui dépasse hors du boitier 20 du module de commande 10 est accessible depuis l'extérieur de l'emballage 50. Les câbles peuvent être accessibles notamment en configuration d'ouverture d'un rabat 502A et protégés par le rabat 502A en configuration de fermeture de celui-ci, ces deux configurations étant expliquées plus loin. Notamment, c'est la partie proche de l'extrémité libre des câbles électriques qui est accessible depuis l'extérieur de l'emballage 50, pour un raccordement électrique à une source d'alimentation, sans devoir déloger le module de commande 10 hors de l'emballage 50.

Selon un mode de réalisation avantageux non limitatif, l'emballage 50 est constitué en une seule pièce formée dans un matériau léger et recyclable, notamment une matière cartonnée, susceptible d'être conformée au moins par pliage à partir d'un patron initial, la paroi de support 52 venant de matière depuis le reste de la pièce constitutive de l'emballage 50. Ce patron initial peut lui-même être obtenu par une opération de découpe ou de formation de lignes de prédécoupe.

Avantageusement, l'emballage 50 est autoportant, qu'il soit vide (c'est-à-dire lorsqu'il ne maintien aucun module de commande 10 en position bloquée) ou qu'il maintienne tout ou partie des modules de commande 10.

Comme cela est visible sur les figures 1, 2 notamment, l'emballage 50 délimite au moins une première partie 501 et une deuxième partie 502 mobile par rapport à la première partie 501. Selon un mode de réalisation, la première partie 501 et la deuxième partie 502 de l'emballage 50 sont reliées l'une à l'autre par au moins une zone de pliage 503 agencée à proximité de la paroi de support 52. Il reste que la première partie 501 pourrait être indépendante de la deuxième partie 502, éventuellement.

La première partie 501 délimite la paroi de support 52. La deuxième partie 502 comprend quant à elle au moins le rabat 502A susceptible de venir occuper une configuration de fermeture (visible sur la figure 2) dans laquelle le rabat 502A est rapporté et fixé de manière réversible contre la première partie 501. Notamment un bord distal du rabat 502A, opposé à un bord où est formée la zone de pliage 503, comprend au moins une languette 58 destinée à s'insérer dans une fente 60 correspondante formée dans la première partie 501. L'insertion de la languette 58 dans la fente 60 permet de maintenir le rabat 502A dans la configuration de fermeture. Une organisation inversée de la fente 60 et de la languette 58 peut être envisagée.

La deuxième partie 502 est conformée de telle sorte que lorsque le rabat 502A occupe sa configuration de fermeture, la deuxième partie 502 recouvre la paroi de support 52 avec interposition d'un intervalle 62 dans lequel sont au moins partiellement logés les modules de commande 10 maintenus en positions bloquées au niveau des découpes de positionnement 54 respectives. Outre les boitiers 20 des modules de commande 10, l'intervalle 62 peut servir à contenir tout ou partie des câbles électriques.

Le rabat 502A de la deuxième partie 502 est susceptible d'occuper une configuration d'ouverture (visible sur la figure 1 ou 3) distincte de la configuration de fermeture, dans laquelle la deuxième partie 502 est spatialement conformée de telle sorte que la paroi de support 54 est accessible depuis l'extérieur de l'emballage 50 d'une manière permettant la mise en place et le retrait des modules de commande 10 respectivement vers ou hors de leurs positions bloquées respectives. Pour permettre le passage de la configuration de fermeture à la configuration d'ouverture, il est nécessaire de sortir la languette 58 hors de la fente 60 correspondante au préalable. Il suffit ensuite d'exercer un pivotement du rabat 502A autour de la zone de pliage 503.

Comme cela est visible sur les figures 1, 3 et 4 notamment, l'emballage 50 délimite au moins un oeillet de maintien 56 associé à chaque découpe de positionnement 54. Chaque oeillet de maintien 56 présente un contour fermé et est disposé à proximité de la découpe de positionnement 54 à laquelle il est associé. L'oeillet de maintien 56 peut être obtenu par le retrait d'une partie centrale de matière prédécoupée dans le patron initial. Le nombre d'oeillets de maintien 56 est égal au nombre de découpes de positionnement 54. Chaque oeillet de maintien 56 est adapté à permettre le passage à travers ledit oeillet de maintien 56 d'au moins un câble électrique dépassant du boitier 20 du module de commande 10 qui est engagé à force dans la découpe de positionnement 54 à laquelle ledit oeillet de maintien 56 est associé, typiquement au moins l'un des câbles électriques L1, N1.

Ces dispositions s'appliquent également dans l'hypothèse où l'emballage ne comprend qu'une unique découpe de positionnement 54, moyennant alors l'aménagement d'un oeillet de maintien 56 à contour fermé disposé à proximité de la découpe de positionnement 54 unique, l'oeillet de maintien 56 étant adapté à permettre le passage à travers ledit oeillet de maintien 56 d'au moins un câble électrique L1, N1 dépassant du boitier 20 du module de commande 10 qui est engagé à force dans la découpe de positionnement 54.

De manière générale, grâce à un tel emballage 50, chaque module de commande 10 est bien maintenu au niveau de la découpe de positionnement 54 correspondante par l'intermédiaire d'au moins l'un de ses câbles L1, N1. En effet, le positionnement assuré par la coopération de forme entre le module de commande 10 et la découpe de positionnement 54 délimitée par l'emballage 50 n'a qu'une résistance limitée. Lors du branchement des câbles L1, N1 sur le banc d'appairage 200, l'installateur peut tirer sur les câbles et extraire involontairement le module de commande 10 hors de la découpe de positionnement 54. Cet effet est minimisé par le passage des câbles L1, N1 dans l'œillet de maintien 56. Non seulement la contrainte sur les extrémités des câbles L1, N1 est moins transmise vers le module de commande 10, mais si jamais le module de commande 10 sort malgré tout de sa découpe de positionnement 54, il reste retenu à l'emballage 50 par le passage des câbles L1, N1 dans l'œillet de maintien 56.

Selon un mode de réalisation, la paroi de support 52 dans laquelle sont ménagées chaque découpe de positionnement 54 est une paroi opposée à une paroi inférieure à poser sur le banc d'appairage 200. L'oeillet de maintien 56 associé à une découpe de positionnement 54 donnée est notamment aménagée sur une paroi latérale par rapport à cette découpe, s'étendant au moins partiellement entre la paroi de support 52 et la paroi inférieure.

Selon un mode de réalisation particulier, l'emballage 50 comprend au moins une zone de repérage 64 accessible depuis l'extérieur de l'emballage 50 permettant de renseigner au moins une information relative à l'installation domotique au sein de laquelle les modules de commande 10 de l'ensemble prédéterminé sont destinés à être utilisés. Il est possible d'utiliser l'emballage pour renseigner de telles informations et le conserver durant le transport pendant tout ou partie du cycle de vie allant du stockage après fabrication jusqu'à la mise en place finale, notamment entre le moment où les modules de commande 10 ont été appairés et réglés via le banc d'appairage 200 et le moment de la mise en place finale sur site de l'installation domotique 100.

Selon un autre mode de réalisation avantageux, pour chaque module de commande 10 maintenu en position bloquée dans l'une des découpes de positionnement 54 délimitées par la paroi de support 52, ce module de commande 10 comprend au moins une zone d'identification 32 accessible depuis l'extérieur de l'emballage 50. La zone d'identification 32 permet de renseigner au moins une information relative au module de commande 10 concerné, notamment au moins une information choisie parmi un nom de repérage, une fonction remplie par le module de commande 10, un nom de la charge électrique 1 destinée à être commandée par le module de commande 10, un nom d'une pièce où le module de commande 10 est destiné à être implanté.

L'invention porte donc sur un système électrique comprenant l'ensemble prédéterminé de modules de commande 10, l'emballage 50 et un banc d'appairage 200 adapté à réaliser un appairage de l'un des modules de commande 10 de l'ensemble prédéterminé avec un autre module de commande 10 de l'ensemble prédéterminé et/ou avec un émetteur radiofréquence distant 5 destiné à être utilisé dans une même installation domotique que les modules de commande 10 de l'ensemble prédéterminé.

La possibilité de pouvoir appairer deux modules de commande 10 est par exemple intéressante dans le cas où l'un d'eux est un module de commande émetteur et l'autre est un module de commande récepteur. Un module de commande émetteur peut être inséré à l'arrière d'un interrupteur mural 4, pour commander une charge électrique 1 (munie d'un module de commande récepteur) sans avoir à tirer de câbles électriques. Ceci peut être très utile en rénovation.

Le banc d'appairage 200 comprend tout ou partie des éléments suivants :
- des éléments de raccordement à une source électrique,
- un bloc d'alimentation électrique 202 permettant d'alimenter électriquement l'émetteur radiofréquence distant 5 depuis le banc d'appairage 200,
- des connecteurs électriques (non représentés) adaptés à une connexion et une déconnexion rapides à au moins l'un des câbles électriques qui dépassent hors du boitier 20 du module de commande 10 et destiné à être connecté à une source électrique d'alimentation du module de commande 10 et/ou à un circuit électrique 2 auquel la charge électrique 1 à commander par le module de commande 10 appartient, lesdits connecteurs électriques permettant une alimentation électrique des modules de commande 10 par le banc d'appairage 200,
- au moins un port d'entrée-sortie pour raccorder le banc d'appairage 200 à l'émetteur radiofréquence distant 5 ou à une interface homme-machine, tel qu'un écran et/ou un clavier,
- des éléments de confirmation 204 visuels et/ou auditifs pour confirmer la présence ou l'absence d'appairage de chacun des modules de commande 10 de l'ensemble prédéterminé avec un autre module de commande 10 et/ou avec l'émetteur radiofréquence distant 5.

Selon l'invention, quel que soit le nombre de découpes de positionnement 54, l'emballage 50 comprend des premiers éléments de fixation configurés pour coopérer avec des seconds éléments de fixation solidaires d'un carter 206 du banc d'appairage 200 d'une manière telle que lorsque les premiers éléments de fixation et les seconds éléments de fixation coopèrent entre eux, l'emballage 50 est fixé temporairement au carter 206 du banc d'appairage 200. Il s'agit de la situation adoptée sur la figure 6. Il est évident qu'il est ensuite possible de séparer l'emballage 50 par rapport au carter 206 une fois que les modules de commande 10 maintenus en positions bloquées dans l'emballage 50 ont été appairés et réglés, permettant à la fois de transporter les modules 10 par l'intermédiaire de l'emballage 50 et de réutiliser le banc d'appairage 200 en coopération avec les modules de commande 10 d'un autre ensemble prédéterminé dont les modules de commande 10 seraient à appairer et à configurer.

A titre d'exemple économique, simple et efficace, les premiers éléments de fixation sont simplement constitués par au moins l'une des fentes 60 tandis que les seconds éléments de fixation sont alors constitués par au moins une lame solidaire du carter 206 (partiellement visible sur la figure 6) et apte à s'engager dans cette fente 60.

Dans le cas particulier d'un système électrique où au moins l'un des modules de commande 10 de l'ensemble prédéterminé est susceptible d'occuper le mode de fonctionnement ou le mode de configuration à plusieurs états de configuration, le banc d'appairage 200 peut comprendre avantageusement d'une part un interrupteur basculant 208 procurant deux positions stables et/ou un interrupteur de type bouton poussoir 210 procurant une unique position stable permettant une sélection de l'état de configuration et d'autre part au moins un témoin lumineux 212 pour vérifier la modification de l'état de configuration et/ou l'état de configuration sélectionné.

La solution présentée précédemment est économique et conviviale, sécuritaire en limitant les risques de perte et d'inversion de modules de commande 10 d'un même ensemble prédéterminé. Les opérations d'appairage et de configuration éventuelle des modules de commande 10 sont facilitées ainsi que la gestion logistique des modules de commande 10 pendant leur cycle de vie depuis le stockage après leur production jusqu'à leur installation finale en passant par différentes étapes de manipulation. L'utilisation d'un seul et même emballage 50 sur ce cycle de vie permet d'offrir une solution respectueuse de l'environnement tout en étant en optimisant l'efficience générale en limitant les pertes de temps et les manipulations inutiles des modules de commande 10 et des déchets.

Un avantage supplémentaire est qu'il est possible de réaliser les opérations d'appairage et de configuration éventuelle des modules de commande 10 sans avoir à complètement les déballer hors de l'emballage 50. Ceci implique un gain de temps important et une simplification de la gestion logistique.

Les dispositions précédentes et avantages ont été décrits en référence à des figures et à des modes de réalisation prévoyant le cas particulier non limitatif où l'emballage 50 délimite une pluralité de découpes de positionnement 54 (dont le nombre est supérieur ou égal à 2), lesquelles permettent de positionner un ou plusieurs modules de commande 10, c'est-à-dire tout ou partie des modules de commande 10 appartenant à un ensemble prédéterminé de modules de commande 10 au sein duquel le nombre de modules de commande est supérieur ou égal à 1. Toutefois, les dispositions et avantages peuvent tout à fait s'appliquer à un système électrique comprenant un ou plusieurs emballages 50 où chaque emballage 50 délimite une unique découpe de positionnement 54.

Autrement dit, selon un mode de réalisation non représenté, le système électrique comprend alors :
- un module de commande 10 destiné à être utilisé dans une installation domotique 100 et configuré pour assurer une commande d'une charge électrique 1,
- un emballage 50, portatif adapté au conditionnement et au transport du module de commande 10, ledit emballage 50 délimitant au moins une paroi de support 52 dans laquelle une découpe de positionnement 54 unique est ménagée, la découpe de positionnement 54 étant configurée de sorte à permettre un emboîtement à force du module de commande 10 par une insertion au moins partielle du module de commande 10 dans la découpe de positionnement 54, ledit emboîtement conférant un blocage relatif du module de commande 10 par rapport à l'emballage 50 et un maintien du module de commande 10 dans une position bloquée,
- un banc d'appairage 200 adapté à réaliser un appairage du module de commande 10 avec un autre module de commande 10 utilisé dans ladite installation domotique 100 et/ou avec un émetteur radiofréquence distant 5 destiné à être utilisé dans ladite installation domotique 100.

Que l'emballage comprenne une ou plusieurs découpes de positionnement 54, l'emballage peut être configuré, dans un mode de réalisation particulier, pour accueillir, sous au moins l'un des modules de commande maintenus, au moins une notice telle qu'une notice d'installation ou un manuel d'utilisation. Dans le cas où l'emballage ne délimite qu'une seule découpe de positionnement 54, ladite au moins une notice ainsi accueillie permet avantageusement d'apporter un poids supplémentaire à la partie inférieure de l'emballage, facilitant son maintien sur le banc d'appairage 200.

## Revendications

1. Système électrique comprenant :
- un ensemble prédéterminé de modules de commande (10) destinés à être utilisés dans une même installation domotique (100), où chaque module de commande (10) est configuré pour assurer une commande d'une charge électrique (1),
- un emballage (50), portatif adapté au conditionnement et au transport de l'ensemble prédéterminé de modules de commande (10), ledit emballage (50) étant tel que le nombre de modules de commande (10) dudit ensemble prédéterminé puisse être supérieur ou égal à 2, préférentiellement supérieur ou égal à 6, ledit emballage (50) délimitant au moins une paroi de support (52) dans laquelle sont ménagées une pluralité de découpes de positionnement (54) où le nombre de découpes de positionnement (54) de ladite pluralité est supérieur ou égal au nombre de modules de commande (10) dudit ensemble prédéterminé, chaque découpe de positionnement (54) étant configurée de sorte à permettre un emboîtement à force de l'un des modules de commande (10) par une insertion au moins partielle de ce module de commande (10) dans la découpe de positionnement (54), ledit emboîtement conférant un blocage relatif du module de commande (10) par rapport à l'emballage (50) et un maintien du module de commande (10) dans une position bloquée,
- un banc d'appairage (200) adapté à réaliser un appairage de l'un des modules de commande (10) de l'ensemble prédéterminé avec un autre module de commande (10) de l'ensemble prédéterminé et/ou avec un émetteur radiofréquence distant (5) destiné à être utilisé dans la même installation domotique (100) que les modules de commande (10) de l'ensemble prédéterminé,
dans lequel l'emballage (50) comprend des premiers éléments de fixation (60) configurés pour coopérer avec des seconds éléments de fixation solidaires d'un carter (206) du banc d'appairage (200) d'une manière telle que lorsque les premiers éléments de fixation (60) et les seconds éléments de fixation coopèrent entre eux, l'emballage (50) est fixé temporairement au carter (206) du banc d'appairage (200).

2. Système électrique selon la revendication 1, dans lequel le banc d'appairage (200) comprend tout ou partie des éléments suivants :
- des éléments de raccordement à une source électrique,
- un bloc d'alimentation électrique (202) permettant d'alimenter électriquement l'émetteur radiofréquence distant (5) depuis le banc d'appairage (200),
- des connecteurs électriques adaptés à une connexion et une déconnexion rapides à au moins un câble électrique (L1, N1) dépassant hors d'un boîtier (20) du module de commande (10) et destiné à être connecté à une source électrique d'alimentation du module de commande (10) et/ou à un circuit électrique (2) auquel la charge électrique (1) à commander par le module de commande (10) appartient, lesdits connecteurs électriques permettant une alimentation électrique des modules de commande (10) par le banc d'appairage (200),
- au moins un port d'entrée-sortie pour raccorder le banc d'appairage (200) à l'émetteur radiofréquence distant (5) ou à une interface homme-machine, tel qu'un écran et/ou un clavier,
- des éléments de confirmation (204) visuels et/ou auditifs pour confirmer la présence ou l'absence d'appairage de chacun des modules de commande (10) de l'ensemble prédéterminé avec un autre module de commande (10) et/ou avec l'émetteur radiofréquence distant (5).

3. Système électrique selon l'une des revendications 1 ou 2, dans lequel au moins l'un des modules de commande (10) de l'ensemble prédéterminé est susceptible d'occuper un mode de fonctionnement ou un mode de configuration comprenant un état initial et une pluralité d'états de configuration et dans lequel le banc d'appairage (200) comprend d'une part un interrupteur basculant (208) procurant deux positions stables et/ou un interrupteur de type bouton poussoir (210) procurant une unique position stable permettant une sélection de l'état de configuration et d'autre part au moins un témoin lumineux (212) pour vérifier la modification de l'état de configuration et/ou l'état de configuration sélectionné.

4. Système électrique selon l'une des revendications 1 à 3, dans lequel l'emballage (50) délimite au moins un oeillet de maintien (56) à contour fermé associé à chaque découpe de positionnement (54) et disposé à proximité de la découpe de positionnement (54) à laquelle il est associé, le nombre d'oeillets de maintien (56) étant égal au nombre de découpes de positionnement (54), chaque oeillet de maintien (56) étant adapté à permettre le passage à travers ledit oeillet de maintien (56) d'au moins un câble électrique (L1, N1) dépassant d'un boîtier (20) du module de commande (10) qui est engagé à force dans la découpe de positionnement (54) à laquelle ledit oeillet de maintien (56) est associé.

5. Système électrique comprenant :
- un module de commande (10) destiné à être utilisé dans une installation domotique (100) et configuré pour assurer une commande d'une charge électrique (1),
- un emballage (50), portatif adapté au conditionnement et au transport du module de commande (10), ledit emballage (50) délimitant au moins une paroi de support (52) dans laquelle une découpe de positionnement (54) unique est ménagée, la découpe de positionnement (54) étant configurée de sorte à permettre un emboîtement à force du module de commande (10) par une insertion au moins partielle du module de commande (10) dans la découpe de positionnement (54), ledit emboîtement conférant un blocage relatif du module de commande (10) par rapport à l'emballage (50) et un maintien du module de commande (10) dans une position bloquée,
- un banc d'appairage (200) adapté à réaliser un appairage du module de commande (10) avec un autre module de commande (10) utilisé dans ladite installation domotique (100) et/ou avec un émetteur radiofréquence distant (5) destiné à être utilisé dans ladite installation domotique (100),
dans lequel l'emballage (50) comprend des premiers éléments de fixation (60) configurés pour coopérer avec des seconds éléments de fixation solidaires d'un carter (206) du banc d'appairage (200) d'une manière telle que lorsque les premiers éléments de fixation (60) et les seconds éléments de fixation coopèrent entre eux, l'emballage (50) est fixé temporairement au carter (206) du banc d'appairage (200).

6. Système électrique selon la revendication 5, dans lequel le banc d'appairage (200) comprend tout ou partie des éléments suivants :
- des éléments de raccordement à une source électrique,
- un bloc d'alimentation électrique (202) permettant d'alimenter électriquement l'émetteur radiofréquence distant (5) depuis le banc d'appairage (200),
- des connecteurs électriques adaptés à une connexion et une déconnexion rapides à au moins un câble électrique (L1, N1) dépassant hors d'un boîtier (20) du module de commande (10) et destiné à être connecté à une source électrique d'alimentation du module de commande (10) et/ou à un circuit électrique (2) auquel la charge électrique (1) à commander par le module de commande (10) appartient, lesdits connecteurs électriques permettant une alimentation électrique de chaque module de commande (10) par le banc d'appairage (200),
- au moins un port d'entrée-sortie pour raccorder le banc d'appairage (200) à l'émetteur radiofréquence distant (5) ou à une interface homme-machine, tel qu'un écran et/ou un clavier,
- des éléments de confirmation (204) visuels et/ou auditifs pour confirmer la présence ou l'absence d'appairage du module de commande (10) avec un autre module de commande (10) et/ou avec l'émetteur radiofréquence distant (5).

7. Système électrique selon l'une des revendications 5 ou 6, dans lequel le module de commande (10) est susceptible d'occuper un mode de fonctionnement ou un mode de configuration comprenant un état initial et une pluralité d'états de configuration et dans lequel le banc d'appairage (200) comprend d'une part un interrupteur basculant (208) procurant deux positions stables et/ou un interrupteur de type bouton poussoir (210) procurant une unique position stable permettant une sélection de l'état de configuration et d'autre part au moins un témoin lumineux (212) pour vérifier la modification de l'état de configuration et/ou l'état de configuration sélectionné.

8. Système électrique selon l'une des revendications 5 à 7, dans lequel l'emballage (50) délimite un oeillet de maintien (56) à contour fermé disposé à proximité de la découpe de positionnement (54) unique, l'œillet de maintien (56) étant adapté à permettre le passage à travers ledit oeillet de maintien (56) d'au moins un câble électrique (L1, N1) dépassant d'un boitier (20) du module de commande (10) qui est engagé à force dans la découpe de positionnement (54).

9. Système électrique selon l'une des revendications 1 à 8, dans lequel chaque module de commande (10) comprend :
- un module d'émission et/ou de réception radiofréquence (12) pour émettre des signaux radiofréquence vers un récepteur radiofréquence distant et/ou recevoir des signaux radiofréquence en provenance d'un émetteur radiofréquence distant (5) destiné à être utilisé dans la même installation domotique (100),
- au moins un commutateur électrique (16) adapté à ouvrir ou fermer le circuit électrique (2) auquel la charge électrique (1) à commander par le module de commande (10) appartient,
- une unité électronique (22) dont une entrée est reliée au module d'émission et de réception radiofréquence (12) et dont une sortie agit sur le commutateur électrique (16).

10. Système électrique selon l'une des revendications 1 à 9, dans lequel l'emballage (50) est constitué en une seule pièce formée dans un matériau léger et recyclable, notamment une matière cartonnée, susceptible d'être conformée au moins par pliage à partir d'un patron initial, la paroi de support (52) venant de matière depuis le reste de la pièce constitutive de l'emballage (50).

11. Système électrique selon l'une des revendications 1 à 10, dans lequel l'emballage (50) délimite au moins une première partie (501) et une deuxième partie (502) mobile par rapport à la première partie (501), où la première partie (501) délimite la paroi de support (52) et où la deuxième partie (502) comprend au moins un rabat (502A) susceptible de venir occuper une configuration de fermeture dans laquelle le rabat (502A) est rapporté et fixé de manière réversible contre la première partie (501), la deuxième partie (502) étant telle que lorsque le rabat (502A) occupe la configuration de fermeture, la deuxième partie (502) recouvre la paroi de support (52) avec interposition d'un intervalle (62) dans lequel chaque module de commande (10) maintenu en position bloquée au niveau d'une découpe de positionnement (54) est partiellement logé.

12. Système électrique selon la revendication 11, dans lequel le rabat (502A) de la deuxième partie (502) est susceptible d'occuper une configuration d'ouverture distincte de la configuration de fermeture et dans laquelle la deuxième partie (502) est spatialement conformée de telle sorte que la paroi de support (52) est accessible depuis l'extérieur de l'emballage (50) d'une manière permettant la mise en place et le retrait de chaque module de commande (10) vers ou hors de sa position bloquée.

13. Système électrique selon l'une des revendications 1 à 12, dans lequel l'emballage (50) comprend au moins une zone de repérage (64) accessible depuis l'extérieur de l'emballage (50) permettant de renseigner au moins une information relative à l'installation domotique (100) au sein de laquelle chaque module de commande (10) est destiné à être utilisé.

14. Système électrique selon l'une des revendications 1 à 13, dans lequel pour chaque module de commande (10) maintenu en position bloquée dans une découpe de positionnement (54), le module de commande (10) comprend au moins une zone d'identification (32) accessible depuis l'extérieur de l'emballage (50), la zone d'identification (32) permettant de renseigner au moins une information relative au module de commande (10), notamment au moins une information choisie parmi un nom de repérage, une fonction remplie par le module de commande (10), un nom de la charge électrique (1) destinée à être commandée par le module de commande (10), un nom d'une pièce où le module de commande (10) est destiné à être implanté.

## Patentansprüche

1. Elektrisches System, umfassend:
- eine vorbestimmte Anordnung von Steuermodulen (10), die dazu bestimmt sind, in derselben Haustechnikanlage (100) verwendet zu werden, wobei jedes Steuermodul (10) dazu eingerichtet ist, eine Steuerung einer elektrischen Last (1) zu ermöglichen,
- eine tragbare Umhüllung (50), die zum Verpacken und Transportieren der vorbestimmten Anordnung von Steuermodulen (10) geeignet ist, wobei die Umhüllung (50) derart ist, dass die Anzahl der Steuermodule (10) der vorbestimmten Anordnung größer oder gleich 2, vorzugsweise größer oder gleich 6 sein kann, wobei die Umhüllung (50) mindestens eine Stützwand (52) begrenzt, in der eine Mehrzahl von Positionierungsausschnitte (54) vorgesehen sind, wobei die Anzahl der Positionierungsausschnitte (54) der Mehrzahl größer oder gleich der Anzahl der Steuermodule (10) der vorbestimmten Anordnung ist, wobei jeder Positionierungsausschnitt (54) derart eingerichtet ist, dass er das kraftschlüssige Steckverbinden eines der Steuermodule (10) durch zumindest teilweises Einführen dieses Steuermoduls (10) in den Positionierungsausschnitt (54) gestattet, wobei dieses Steckverbinden eine relative Blockierung des Steuermoduls (10) in Bezug auf die Umhüllung (50) und ein Halten des Steuermoduls (10) in einer blockierten Position bietet,
- ein Kopplungssystem (200), das dazu geeignet ist, eine Kopplung eines der Steuermodule (10) der vorbestimmten Anordnung mit einem anderen Steuermodul (10) der vorbestimmten Anordnung und/oder mit einem entfernten Funkfrequenzsender (5), der dazu bestimmt ist, in derselben Haustechnikanlage (100) wie die Steuermodule (10) der vorbestimmten Anordnung verwendet zu werden, durchzuführen,
wobei die Umhüllung (50) erste Befestigungselemente (60) umfasst, die dazu eingerichtet sind, mit zweiten Befestigungselementen zusammenwirken, die fest mit einem Gehäuse (206) des Kopplungssystems (200) auf eine Weise verbunden sind, dass, wenn die ersten Befestigungselemente (60) und die zweiten Befestigungselemente miteinander zusammenwirken, die Umhüllung (50) temporär am Gehäuse (206) des Kopplungssystems (200) befestigt ist.

2. Elektrisches System nach Anspruch 1, bei dem das Kopplungssystem (200) alle oder einen Teil der folgenden Elemente umfasst:
- Anschlusselemente zu einer Stromquelle,
- ein Netzteil (202), das die Stromversorgung des entfernten Funkfrequenzsenders (5) von dem Kopplungssystem (200) gestattet,
- elektrische Steckverbinder, die für ein schnelles Verbinden und Trennen von mindestens einem elektrischen Kabel (L1, N1) geeignet sind, das aus einem Kasten (20) des Steuermoduls (10) herausragt und dazu bestimmt ist, an eine Stromquelle des Steuermoduls (10) und/oder an einen Stromkreis (2), zu dem die durch das Steuermodul (10) zu steuernde elektrische Last (1) gehört, angeschlossen zu werden, wobei die elektrischen Steckverbinder eine Stromversorgung der Steuermodule (10) über das Kopplungssystem (200) gestatten,
- mindestens einen Eingang-Ausgang-Anschluss zum Anschließen des Kopplungssystems (200) an dem entfernten Funkfrequenzsender (5) oder an eine Mensch-Maschine-Schnittstelle, wie etwa einen Bildschirm und/oder eine Tastatur,
- visuelle und/oder akustische Bestätigungselemente (204), um das Vorhandensein oder Fehlen einer Kopplung jedes der Steuermodule (10) der vorbestimmten Anordnung mit einem anderen Steuermodul (10) und/oder mit dem entfernten Funkfrequenzsender (5) zu bestätigen.

3. Elektrisches System nach einem der Ansprüche 1 oder 2, bei dem mindestens eines der Steuermodule (10) der vorbestimmten Anordnung fähig ist, einen Betriebsmodus oder einen Konfigurationsmodus einzunehmen, der einen Ausgangszustand und eine Mehrzahl von Konfigurationszuständen umfasst, und bei dem das Kopplungssystem (200) einerseits einen Kippschalter (208), der zwei feste Positionen bietet, und/oder einen Druckknopfschalter (210), der eine einzige feste Position bietet, die eine Auswahl des Konfigurationszustands gestattet, und andererseits mindestens eine Kontrollleuchte (212) umfasst, um die Änderung des Konfigurationszustands und/oder den ausgewählten Konfigurationsstatus zu kontrollieren.

4. Elektrisches System nach einem der Ansprüche 1 bis 3, bei dem die Umhüllung (50) mindestens eine Halteöse (56) mit geschlossener Kontur begrenzt, die jedem Positionierungsausschnitt (54) zugeordnet ist und in der Nähe des Positionierungsausschnitts (54), dem sie zugeordnet ist, angeordnet ist, wobei die Anzahl der Halteösen (56) gleich der Anzahl der Positionierungsausschnitte (54) ist, wobei jede Halteöse (56) dazu geeignet ist, mindestens einem elektrischen Kabel (L1, N1), das aus einem Kasten (20) des Steuermoduls (10) herausragt und kraftschlüssig in den der Halteöse (56) zugeordneten Positionierungsausschnitt (54) eingreift, den Durchgang durch die Halteöse (56) zu gestatten.

5. Elektrisches System, umfassend:
- ein Steuermodul (10), das dazu bestimmt ist, in derselben Haustechnikanlage (100) verwendet zu werden, und dazu eingerichtet ist, eine Steuerung einer elektrischen Last (1) zu ermöglichen,
- eine tragbare Umhüllung (50), die zum Verpacken und Transportieren des Steuermoduls (10) geeignet ist, wobei die Umhüllung (50) mindestens eine Stützwand (52) begrenzt, in der ein einzelner Positionierungsausschnitt (54) vorgesehen ist, wobei der Positionierungsausschnitt (54) derart eingerichtet ist, dass er das kraftschlüssige Steckverbinden des Steuermoduls (10) durch zumindest teilweises Einführen des Steuermoduls (10) in den Positionierungsausschnitt (54) gestattet, wobei das Steckverbinden eine relative Blockierung des Steuermoduls (10) in Bezug auf die Umhüllung (50) und ein Halten des Steuermoduls (10) in einer blockierten Position bietet,
- ein Kopplungssystem (200), das dazu geeignet ist, eine Kopplung des Steuermoduls (10) mit einem anderen Steuermodul (10), das in Haustechnikanlage (100) verwendet wird, und/oder mit einem entfernten Funkfrequenzsender (5), der dazu bestimmt ist, in der Haustechnikanlage (100) verwendet zu werden, durchzuführen,
wobei die Umhüllung (50) erste Befestigungselemente (60) umfasst, die dazu eingerichtet sind, mit zweiten Befestigungselementen zusammenwirken, die fest mit einem Gehäuse (206) des Kopplungssystems (200) auf eine Weise verbunden sind, dass, wenn die ersten Befestigungselemente (60) und die zweiten Befestigungselemente miteinander zusammenwirken, die Umhüllung (50) temporär am Gehäuse (206) des Kopplungssystems (200) befestigt ist.

6. Elektrisches System nach Anspruch 5, bei dem das Kopplungssystem (200) alle oder einen Teil der folgenden Elemente umfasst:
- Anschlusselemente zu einer Stromquelle,
- ein Netzteil (202), das die Stromversorgung des entfernten Funkfrequenzsenders (5) von dem Kopplungssystem (200) gestattet,
- elektrische Steckverbinder, die für ein schnelles Verbinden und Trennen von mindestens einem elektrischen Kabel (L1, N1) geeignet sind, das aus einem Kasten (20) des Steuermoduls (10) herausragt und dazu bestimmt ist, an eine Stromquelle des Steuermoduls (10) und/oder an einen Stromkreis (2), zu dem die durch das Steuermodul (10) zu steuernde elektrische Last (1) gehört, angeschlossen zu werden, wobei die elektrischen Steckverbinder eine Stromversorgung jedes Steuermoduls (10) über das Kopplungssystem (200) gestatten,
- mindestens einen Eingang-Ausgang-Anschluss zum Anschließen des Kopplungssystems (200) an dem entfernten Funkfrequenzsender (5) oder an eine Mensch-Maschine-Schnittstelle, wie etwa einen Bildschirm und/oder eine Tastatur,
- visuelle und/oder akustische Bestätigungselemente (204), um das Vorhandensein oder Fehlen einer Kopplung des Steuermoduls (10) mit einem anderen Steuermodul (10) und/oder mit dem entfernten Funkfrequenzsender (5) zu bestätigen.

7. Elektrisches System nach einem der Ansprüche 5 oder 6, bei dem das Steuermodul (10) fähig ist, einen Betriebsmodus oder einen Konfigurationsmodus einzunehmen, der einen Ausgangszustand und eine Mehrzahl von Konfigurationszuständen umfasst, und bei dem das Kopplungssystem (200) einerseits einen Kippschalter (208), der zwei feste Positionen bietet, und/oder einen Druckknopfschalter (210), der eine einzige feste Position bietet, die eine Auswahl des Konfigurationszustands gestattet, und andererseits mindestens eine Kontrollleuchte (212) umfasst, um die Änderung des Konfigurationszustands und/oder den ausgewählten Konfigurationsstatus zu kontrollieren.

8. Elektrisches System nach einem der Ansprüche 5 bis 7, bei dem die Umhüllung (50) mindestens eine Halteöse (56) mit geschlossener Kontur begrenzt, die in der Nähe des einzelnen Positionierungsausschnitts (54) angeordnet ist, wobei die Halteöse (56) dazu geeignet ist, mindestens einem elektrischen Kabel (L1, N1), das aus einem Kasten (20) des Steuermoduls (10) herausragt und kraftschlüssig in den Positionierungsausschnitt (54) eingreift, den Durchgang durch die Halteöse (56) zu gestatten.

9. Elektrisches System nach einem der Ansprüche 1 bis 8, bei dem jedes Steuermodul (10) Folgendes umfasst:
- ein Funkfrequenz-Sende- und/oder Empfangsmodul (12) zum Senden von Funkfrequenzsignalen an einen entfernten Funkfrequenzempfänger und/oder zum Empfangen von Funkfrequenzsignalen von einem entfernten Funkfrequenzsender (5), das dazu bestimmt ist, in derselben Haustechnikanlage (100) verwendet zu werden,
- mindestens einen elektrischen Schalter (16), der dazu geeignet ist, den Stromkreis (2) zu öffnen oder zu schließen, zu dem die durch das Steuermodul (10) zu steuernde elektrische Last (1) gehört,
- eine elektronische Einheit (22), deren einer Eingang mit dem Funkfrequenz-Sende- und Empfangsmodul (12) verbunden ist und deren einer Ausgang den elektrischen Schalter (16) bedient.

10. Elektrisches System nach einem der Ansprüche 1 bis 9, bei dem die Umhüllung (50) aus einem einzigen Bauteil besteht, das aus einem leichten und recycelbaren Material, insbesondere einem Kartonmaterial, ausgebildet ist, das fähig ist, zumindest durch Falten ausgehend von einem ursprünglichen Muster geformt zu werden, wobei die Stützwand (52) aus Material vom Rest des Bestandteils der Umhüllung (50) besteht.

11. Elektrisches System nach einem der Ansprüche 1 bis 10, bei dem die Umhüllung (50) mindestens einen ersten Teil (501) und einen zweiten Teil (502), der in Bezug auf den ersten Teil (501) beweglich ist, begrenzt, wobei der erste Teil (501) die Stützwand (52) begrenzt und der zweite Teil (502) mindestens eine Klappe (502A) umfasst, die fähig ist, eine geschlossene Konfiguration einzunehmen, in der die Klappe (502A) reversibel am ersten Teil (501) angebracht und befestigt ist, wobei der zweite Teil (502) derart ist, dass, wenn die Klappe (502A) die geschlossene Konfiguration eingenommen hat, der zweite Teil (502) die Stützwand (52) mit einem dazwischenliegenden Abstand (62) abdeckt, in dem jedes sich in der blockierten Position befindliche Steuermodul (10) teilweise in einem Positionierungsausschnitt (54) untergebracht ist.

12. Elektrisches System nach Anspruch 11, bei dem die Klappe (502A) des zweiten Teils (502) fähig ist, eine geöffnete Konfiguration einzunehmen, die sich von der geschlossenen Konfiguration unterscheidet und in der der zweite Teil (502) räumlich derart ausgelegt ist, dass er die Stützwand (52) von außerhalb der Umhüllung (50) auf eine Weise zugänglich ist, dass jedes Steuermodul (10) in seiner blockierten Position platziert und aus dieser entfernt werden kann.

13. Elektrisches System nach einem der Ansprüche 1 bis 12, bei dem die Umhüllung (50) mindestens einen Erfassungsbereich (64) umfasst, der von außerhalb der Umhüllung (50) zugänglich ist und es gestattet, die Eingabe mindestens einer Information in Bezug auf die Haustechnikanlage (100) zu überprüfen, in der jedes Steuermodul (10) verwendet werden soll.

14. Elektrisches System nach einem der Ansprüche 1 bis 13, bei dem das Steuermodul (10) für jedes Steuermodul (10), das in einem Positionierungsausschnitt (54) in einer blockierten Position gehalten wird, mindestens einen Identifikationsbereich (32) umfasst, der von außerhalb der Umhüllung (50) zugänglich ist, wobei der Identifikationsbereich (32) die Eingabe mindestens einer Information in Bezug auf das Steuermodul (10), insbesondere mindestens einer Information ausgewählt aus einem Namen der Erfassung, einer vom Steuermodul (10) ausgeführten Funktion, einem Namen der elektrischen Last (1), die dazu bestimmt ist, vom Steuermodul (10) gesteuert zu werden, und einem Namen eines Raums, in dem das Steuermodul (10) implementiert werden soll, gestattet.

## Claims

1. An electrical system comprising:
- a predetermined set of control modules (10) intended to be used in a same home automation installation (100), wherein each control module (10) is configured to ensure control of an electric load (1),
- a portable packaging (50), adapted for packaging and transport of the predetermined set of control modules (10), said packaging (50) being such that the number of control modules (10) of said predetermined set can be greater than or equal to 2, preferably greater than or equal to 6, said packaging (50) delimiting at least one support wall (52) in which a plurality of positioning cutouts (54) are formed, where the number of positioning cutouts (54) of said plurality is greater than or equal to the number of control modules (10) of said predetermined set, each positioning cutout (54) being configured so as to allow a force fitting of one of the control modules (10) by at least partial insertion of this control module (10) in the positioning cutout (54), said force fitting conferring a relative blocking of the control module (10) with respect to the packaging (50) and a holding of the control module (10) in a blocked position,
- a pairing bank (200) adapted to carry out a pairing of one of the control modules (10) of the predetermined set with another control module (10) of the predetermined set and/or with a remote radio frequency transmitter (5) intended to be used in the same home automation system (100) as the control modules (10) of the predetermined set,
wherein the packaging (50) comprises first fastening elements (60) configured to cooperate with second fastening elements secured to a casing (206) of the pairing bank (200) in such a way that when the first fastening elements (60) and the second fastening elements cooperate with each other, the packaging (50) is temporarily fastened to the casing (206) of the pairing bank (200).

2. The electrical system according to claim 1, wherein the pairing bank (200) comprises all or part of the following elements:
- elements for connecting to an electrical source,
- an electric power supply unit (202) making it possible to electrically power the remote radio frequency transmitter (5) from the pairing bank (200),
- electrical connectors adapted for quick connection and disconnection to at least one electrical cable (L1, N1) protruding from a case (20) of the control module (10) and intended to be connected to an electric power supply source of the control module (10) and/or to an electric circuit (2) to which the electric load (1) to be controlled by the control module (10) belongs, said electrical connectors allowing an electric power supply to the control modules (10) by the pairing bank (200),
- at least one input-output port for linking the pairing bank (200) to the remote radio frequency transmitter (5) or to a man-machine interface, such as a screen and/or a keyboard,
- visual and/or auditory confirmation elements (204) to confirm the presence or absence of pairing of each of the control modules (10) of the predetermined set with another control module (10) and/or with the remote radio frequency transmitter (5).

3. The electrical system according to any of claims 1 or 2, wherein at least one of the control modules (10) of the predetermined set is likely to occupy an operating mode or a configuration mode comprising an initial state and a plurality of configuration states and wherein the pairing bank (200) comprises on the one hand a rocker switch (208) providing two stable positions and/or a push-button type switch (210) providing a single stable position allowing a selection of the configuration state and on the other hand at least one indicator light (212) to verify the modification of the configuration state and/or the selected configuration state.

4. The electrical system according to any of claims 1 to 3, wherein the packaging (50) delimits at least one retaining eyelet (56) with a closed outline associated with each positioning cutout (54) and arranged close to the positioning cutout (54) with which it is associated, the number of retaining eyelets (56) being equal to the number of positioning cutouts (54), each retaining eyelet (56) being adapted to allow passage through said retaining eyelet (56) of at least one electrical cable (L1, N1) protruding from a case (20) of the control module (10) which is forcibly engaged in the positioning cutout (54) with which said retaining eyelet (56) is associated.

5. The electrical system comprising:
- a control module (10) intended to be used in a home automation installation (100) and configured to ensure control of an electric load (1),
- a portable packaging (50), adapted for packaging and transport of the control module (10), said packaging (50) delimiting at least one support wall (52) in which a single positioning cutout (54) is formed, the positioning cutout (54) being configured so as to allow a force fitting of the control module (10) by at least partial insertion of the control module (10) in the positioning cutout (54), said force fitting conferring a relative blocking of the control module (10) with respect to the packaging (50) and a holding of the control module (10) in a blocked position,
- a pairing bank (200) adapted to carry out a pairing of the control module (10) with another control module (10) used in said home automation installation (100) and/or with a remote radio frequency transmitter (5) intended to be used in said home automation installation (100),
wherein the packaging (50) comprises first fastening elements (60) configured to cooperate with second fastening elements secured to a casing (206) of the pairing bank (200) in such a way that when the first fastening elements (60) and the second fastening elements cooperate with each other, the packaging (50) is temporarily fastened to the casing (206) of the pairing bank (200).

6. The electrical system according to claim 5, wherein the pairing bank (200) comprises all or part of the following elements:
- elements for connecting to an electrical source,
- an electric power supply unit (202) making it possible to electrically power the remote radio frequency transmitter (5) from the pairing bank (200),
- electrical connectors adapted for quick connection and disconnection to at least one electrical cable (L1, N1) protruding from a case (20) of the control module (10) and intended to be connected to an electric power supply source of the control module (10) and/or to an electric circuit (2) to which the electric load (1) to be controlled by the control module (10) belongs, said electrical connectors allowing an electric power supply of each control module (10) by the pairing bank (200),
- at least one input-output port for linking the pairing bank (200) to the remote radio frequency transmitter (5) or to a man-machine interface, such as a screen and/or a keyboard,
- visual and/or auditory confirmation elements (204) to confirm the presence or absence of pairing of the control module (10) with another control module (10) and/or with the remote radio frequency transmitter (5).

7. The electrical system according to any of claims 5 or 6, wherein the control module (10) is likely to occupy an operating mode or a configuration mode comprising an initial state and a plurality of configuration states and wherein the pairing bank (200) comprises on the one hand a rocker switch (208) providing two stable positions and/or a push-button type switch (210) providing a single stable position allowing a selection of the configuration state and on the other hand at least one indicator light (212) to verify the modification of the configuration state and/or the selected configuration state.

8. The electrical system according to any of claims 5 to 7, wherein the packaging (50) delimits a retaining eyelet (56) with a closed outline arranged close to the single positioning cutout (54), the retaining eyelet (56) being adapted to allow passage through said retaining eyelet (56) of at least one electrical cable (L1, N1) protruding from a case (20) of the control module (10) which is forcibly engaged in the positioning cutout (54).

9. The electrical system according to any of claims 1 to 8, wherein each control module (10) comprises:
- a radio frequency transmission and/or reception module (12) for transmitting radio frequency signals to a remote radio frequency receiver and/or receiving radio frequency signals from a remote radio frequency transmitter (5) intended to be used in the same home automation installation (100),
- at least one electrical switch (16) adapted to open or close the electric circuit (2) to which the electric load (1) to be controlled by the control module (10) belongs,
- an electronic unit (22) one input of which is connected to the radio frequency transmission and reception module (12) and one output of which acts on the electrical switch (16).

10. The electrical system according to any of claims 1 to 9, wherein the packaging (50) is made in one piece formed in a light and recyclable material, in particular a cardboard material, likely to be shaped at least by folding from an initial pattern, the support wall (52) being integral with the rest of the component part of the packaging (50).

11. The electrical system according to any of claims 1 to 10, wherein the packaging (50) delimits at least one first portion (501) and one second portion (502) movable relative to the first portion (501), wherein the first portion (501) delimits the support wall (52) and wherein the second portion (502) comprises at least one flap (502A) likely to occupy a closure configuration in which the flap (502A) is reversibly mounted and fastened against the first portion (501), the second portion (502) being such that when the flap (502A) occupies the closure configuration, the second portion (502) covers the support wall (52) with the interposition of a gap (62) in which each control module (10) held in the blocked position at a positioning cutout (54) is partially housed.

12. The electrical system according to claim 11, wherein the flap (502A) of the second portion (502) is likely to occupy an opening configuration distinct from the closure configuration and in which the second portion (502) is spatially shaped so that the support wall (52) is accessible from outside the package (50) in a manner allowing the set-up and removal of each control module (10) into or out of its blocked position.

13. The electrical system according to any of claims 1 to 12, wherein the packaging (50) comprises at least one marking area (64) accessible from outside the packaging (50) making it possible to provide at least one information relating to the home automation installation (100) within which each control module (10) is intended to be used.

14. The electrical system according to any of claims 1 to 13, wherein for each control module (10) held in the blocked position in a positioning cutout (54), the control module (10) comprises at least one identification area (32) accessible from outside the packaging (50), the identification area (32) making it possible to provide at least one information relating to the control module (10), in particular at least one information selected from a marking name, a function fulfilled by the control module (10), a name of the electric load (1) intended to be controlled by the control module (10), a name of a part where the control module (10) is intended to be installed.
